(19) Europäisches Patentamt
European Patent Office
Office européen des brevets

(11) EP 2 369 745 B1

(12) EUROPEAN PATENT SPECIFICATION

(45) Date of publication and mention
of the grant of the patent:
15.04.2015 Bulletin 2015/16

(51) Int Cl.:
*H03L 7/089* (2006.01)     *H03L 7/197* (2006.01)

(21) Application number: 11159357.0

(22) Date of filing: 23.03.2011

(54) **Method and apparatus for quantization noise reduction in fractional-N PLLS**

Verfahren und Vorrichtung zur Quantifizierung der Rauschunterdrückung in einem Fractional-N-PLLS

Procédé et appareil pour quantifier la réduction de bruit dans un PLLS à pas fractionnaire

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.03.2010 US 732029
25.03.2010 US 732024**

(43) Date of publication of application:
**28.09.2011 Bulletin 2011/39**

(73) Proprietor: **Silicon Laboratories Inc.
Austin, TX 78701 (US)**

(72) Inventor: **Yu, Qicheng
Austin, TX 78701 (US)**

(74) Representative: **Appelt, Christian W. et al
Boehmert & Boehmert
Anwaltspartnerschaft mbB
Patentanwälte Rechtsanwälte
Pettenkoferstrasse 20-22
80336 München (DE)**

(56) References cited:
**US-A- 5 436 596       US-A1- 2003 222 723
US-A1- 2007 126 484     US-A1- 2009 285 279**

**Description**

**BACKGROUND**

**Technical Field**

This application relates to fractional-N phase-locked loops and more particularly to correcting shortcomings in such phase-locked loops (PLLs).

**Background Art**

Wide band fractional-*N* PLLs see increasing demand in various fields, especially wireless communications. Large bandwidth of the PLL helps suppress the intrinsic noise of the VCO, and provides fast settling time during frequency switching.

Unlike an integer-*N* PLL, the feedback divider output clock (fbclk leads and lags the reference clock (refclk) regularly in a fractianal-*N* PLL due to an ever-changing frequency divider ratio. The change is necessary to maintain an average VCO clock to reference clock frequency ratio that contains a fraction. This quantization noise of the feedback clock phase is injected through the phase-frequency detector (PFD) and charge pump (CP), and easily becomes the dominant noise source of the system. Meanwhile, the CP exhibits nonlinearity, mainly due to the size mismatch between the up and down current sources. High frequency quantization noise is modulated by the nonlinearity down into the pass band of the PLL, corrupting the output clock.

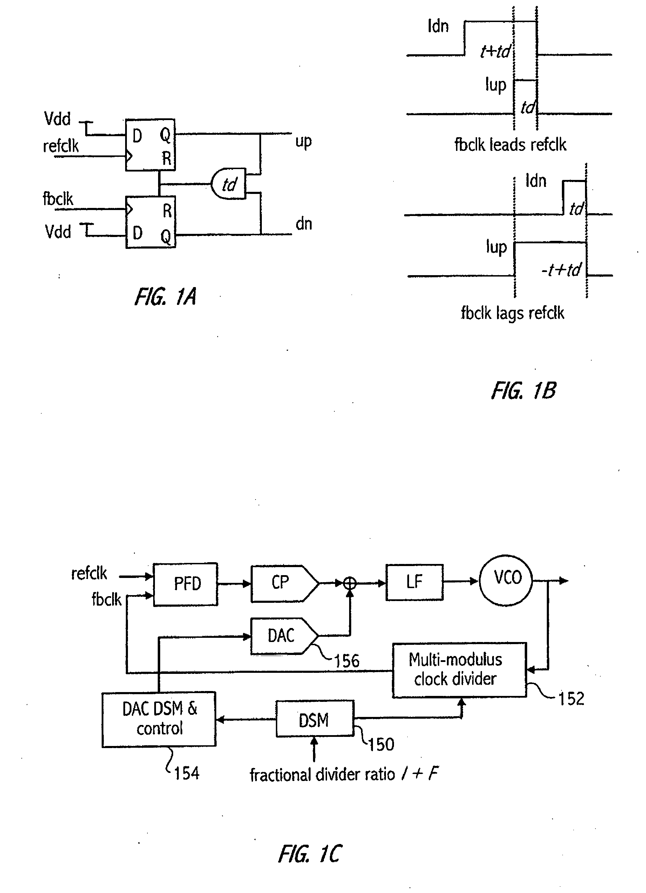

Referring to Fig. 1, illustrated is a typical tri-state PFD used to drive the charge pump of a PLL. In locked steady state operation, the rising edge of the refclk triggers the up output pulse and the rising edge of the fbclk triggers the down output pulse. A short delay after both pulses rise, the PFD is reset and both pulses clear simultaneously (Fig. 1 (b)). The total charge $Q$ delivered by the charge pump to the loop filter is

$$Q = I_{up} \cdot t_d - I_{dn} \cdot t - I_{dn} \cdot t_d$$

when fbclk leads, and

$$Q = I_{up} \cdot (-t) + I_{up} \cdot t_d - I_{dn} \cdot t_d$$

when fbclk lags. Here $t$ is the time by which the fbclk leads refclk, $t_d$ is the delay of reset in the PFD, and $I_{up}$ and $I_{dn}$ are the value of up and down current sources. $Q$ is nonlinear with respect to t if $I_{up} \neq I_{dn}$, causing the high frequency quantization noise in the phase of fbclk to alias into the PLL bandwidth.

Another source of error as described above is the quantization noise due to the feedback divider output clock (fbclk) leading and lagging the reference clock (refclk) regularly in a fractional-*N* PLL due to an ever-changing frequency divider ratio. The common approach to quantization noise reduction is to add dedicated current sources to implement a canceling digital to analog converter (DAC), which delivers a charge that is nearly the opposite of the quantization noise. A typical fractional-N PLL with quantization noise reduction is shown in Fig. 1C. The delta-sigma modulator (DSM) 150 not only determines the instantaneous feedback divider ratio for multi-modulus divider 152, but also provides the phase difference of the fbclk relative to the refclk for the digital control circuit 154 for the cancellation digital to analog converter (DAC) 156. The DAC 156 is typically a separate bank of current sources, each of which may turn on for a short duration that is approximately aligned with the charge pump (CP) current pulses. The DAC is controlled by a second delta-sigma modulator (DAC DSM) 154 that modulates its own quantization noise out of the PLL pass band. The penalties to pay for the added circuit components include thermal and 1/f noise, switch charge injection, error charge due to component mismatch, device leakage current and supply current. While the average total current is zero, the different current pulses have different amplitude, duration and skew, resulting in residual noise at high frequencies.

US 2007/126484 A1 describes a circuit, with applications to phase-locked loops and frequency synthesis, where a divider circuit shuffles between dividing the output of a voltage-controlled oscillator by N or N+1, where N is an integer, and where a phase frequency detector provides three logic signals to a charge pump so that one of three values of current may be sourced to a loop filter, with the result that the circuit behaves as a conventional phase-locked loop having a fictitious divider circuit that is capable of dividing the output of the voltage-controlled oscillator by a non-integral value.

## SUMMARY OF THE INVENTION

Thus, it is an object of the invention to suggest improvements at controlling noise, charge injection, mismatch error and leakage current in a PLL. The object is solved by the subject matter of the independent claims. Advantageous embodiments are subject to the dependent claims.

## Brief Description of Drawings

The present invention may be better understood, and its numerous objects, features, and advantages made apparent to those skilled in the art by referencing the accompanying drawings.

FIG. lA illustrates a typical PFD used to drive a charge pump in a PLL.

Fig. 1B illustrates a timing diagram associated with the PFD of Fig. 1A.

Fig. 1C illustrates a quantization noise reduction technique using a dedicated noise canceling DAC.

Fig. 2 illustrates a linearizing PFD according to an embodiment of the invention.

Fig. 3 illustrates a timing diagram associated with the linearizing PFD of Fig. 2.

Fig. 4 illustrates a NAND gate implementation of the linearizing PFD shown in Fig. 2.

Fig. 5A illustrates timing with an imagined RVCO where fbclk leads refclk.

Fig. 5B illustrates timing with an imagined RVCO where refclk leads fbclk.

Fig. 5C illustrates an example where the RVCO clock period is Tvco/4.

Fig. 6 illustrates an exemplary fractional-N PLL 600 with charge pump linearization and quantization noise reduction according to an embodiment of the invention.

Fig. 7 illustrates an embodiment of charge pump control logic according to an embodiment of the invention.

Fig. 8 illustrates a self correcting mechanism that may be used in an embodiment.

Fig. 9 illustrates an identically shaped pair of up and down current pulses with a systematic skew.

Fig. 10 illustrates pulse width invariant PFD according to an embodiment of the invention.

The use of the same reference symbols in different drawings indicates similar or identical items.

## MODE(S) FOR CARRYING OUT THE INVENTION

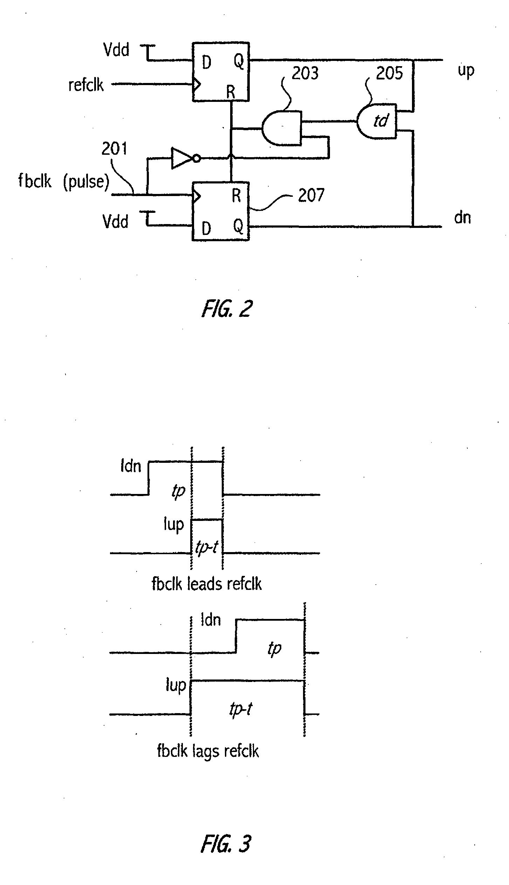

Referring to Fig. 2, a linearizing PFD is illustrated that provides charge pump linearization to address mismatch nonlinearity according to an embodiment of the invention. Given that the rising edges of the up and down pulses are triggered by rising edges of the reference clock (refclk) and the feedback clock (fbclk), the charge Q can be linearized by making the down pulse a constant-width, $t_p$. The down pulse is made wide enough to accommodate the quantization noise on fbclk, so that the up pulse always rises (with certain exceptions noted below) before the down pulse falls. Also, in the linearizing PFD, the up pulse is made to fall when the down pulse falls due to the fall of the fbclk. Note that the feedback clock (fbclk) should be a constant-width pulse, instead of a 50% duty cycle clock. The fbclk pulse can be generated in the feedback clock divider and retimed with the VCO clock, and the pulse $t_p$ is typically two to four VCO clock periods long. In an embodiment, the fbclk pulse is made inside the feedback clock divider using a small state machine in the feedback divider that generates the back edge (falling edge) of the fbclk a fixed number of VCO clock periods after the front edge of the fbclk. Both the front and back edges of the fbclk pulse are retimed with the VCO clock. In other embodiments, the small state machine is moved into the linearizing PFD and retimed with the VCO clock in the PFD. Alternatively, the fbclk (pulse) could be generated with a one-shot either in the divider or in the PFD.

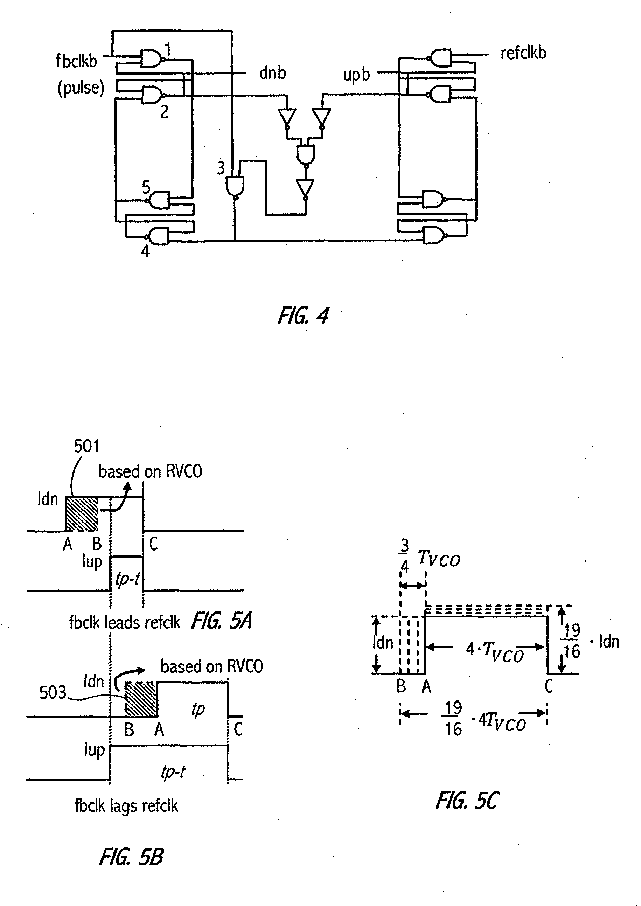

For the linearizing PFD to behave in the same way as the classical PFD during frequency acquisition, fbclk (pulse) should not be stuck high. The up pulse falls when the down pulse falls, that is, when the fbclk pulse on node 201 falls, the AND gate 203 output resets the D flip-flops, assuming that refclk has been received and the up pulse rose before the fbclk pulse falls. A NAND gate realization of the linearizing PFD is shown in Fig. 4, where all inputs and outputs are in inverted sense.

Fig. 3 shows the timing of the up and down CP current pulses when fbclk leads or lags the refclk for the embodiment shown in Fig. 2. In both cases, the charge Q= $I_{up}$· (-t) + $I_{up}$ · $t_p$ - $I_{dn}$ · $t_p$. Since the $I_{dn}$ contribution to $Q$ is constant, mismatch nonlinearity is eliminated. When refclk lags fbclk by more than $t_p$, during PLL frequency acquisition, for instance, the down pulse should be extended to fall together with the up pulse, at time $t_d$ after up pulse rises. Thus, AND gate 205 ensures the down pulse is extended by ensuring that flip-flop 207 is not reset. In this case, the modified PFD behaves like the tri-state PFD shown in Fig. 1A.

*Quantization Noise Reduction*

Having linearized the charge pump with a constant-width down current pulse and causing the up pulse to fall with the down pulse, a quantization noise reduction technique according to an embodiment uses the down current itself as the cancellation DAC.

The quantization noise of fractional-*N* division from the DSM is directly proportional to the VCO clock period, $T_{VCO}$. Imagine there is a "quantization noise reduction VCO" (RVCO) that runs at four times the VCO frequency and is phase aligned to the VCO. If an RVCO clock edge, instead of a VCO clock edge, is used to generate the fbclk and the down pulse rising edges, it would be four times closer to the rising edge of the up pulse. The quantization noise is reduced by a factor of four, if a "quantization noise reduction delta-sigma modulator" (RDSM), similar to the DSM, is used with another clock divider to generate fbclk from RVCO. The divide ratio of this clock divider is approximately four times that of the original clock divider. Meanwhile, the falling edge of the down pulse should remain in the previous location based on the VCO clock edge. This is depicted in Figs. 5A and 5B. Edges A and C are the rising and falling edge locations of the original down pulse, both aligned with VCO clock edges. Edges B and C are the rising and falling edge locations of the down pulse based on RDSM. Edge B is aligned with a RVCO clock edge, but not necessarily a VCO clock edge. In Fig. 5A, where fbclk leads refclk, the shaded area 501 represents quantization noise charge reduction if the feedback clock edge was moved from A to B. In Fig. 5B, where refclk leads fbclk, the shaded area 503 represents quantization noise charge reduction achieved assuming the charge represented by the shaded area 543 is supplied to the charge pump.

Consider an example where $t_p$ = 4 · $T_{VCO}$, and RVCO clock period is $\dfrac{T_{VCO}}{4}$. Remember, $t_p$ represents a constant-width down pulse. Referring to Fig. 5C, assume the DSM (controlling the feedback divider) chooses VCO clock edge A for the rising edge of the down pulse, whereas the RDSM chooses RVCO clock edge B for the rising edge of the down pulse, and B is $\left(\dfrac{3}{4}\right)T_{VCO}$ before A. The falling edge of the down pulse is C for both cases, where RVCO and VCO clock edges overlap. C is 4 · $T_{VCO}$ behind A. That is, the RDSM requires a down current pulse that is $I_{dn}$ in amplitude and

$$\frac{3}{4}T_{VCO} + 4 \cdot T_{VCO} = \left(\frac{19}{16}\right) \cdot 4 T_{VCO}$$

in width. In reality, RVCO and associated clock edges do not exist. However, the same charge can be injected by a down current pulse that is $\left(\dfrac{19}{16}\right) \cdot I_{dn}$ in amplitude and 4 · $T_{VCO}$ in width, based on the VCO clock and the DSM rather than requiring an RVCO. Instead of a single current source of amplitude $I_{dn}$, the CP down current is implemented as 32 current source units of $\left(\dfrac{1}{16}\right) \cdot I_{dn}$ each, and 19 of them are turned on in this case.

As is typical with current-DAC based quantization noise cancellation schemes, desired pulse-width modulation is replaced by feasible pulse-amplitude modulation. Here, turning on each current source unit adds $\dfrac{T_{VCO}}{4}$ to the effective down pulse width, and turning on between zero and 32 units corresponds to an effective pulse width of zero to $8 T_{VCO}$.

On average over time, both DSM and RDSM would choose a location of the down pulse rising edge that aligns with the up pulse rising edge. Therefore, there are 16 current source units active on average to provide a charge, on average, equal to that delivered by the up pulse. Instead of eliminating quantization noise entirely, the quantization noise reduction technique aims to suppress it so that it is significantly below the noise of the rest of the system.

*System Implementation*

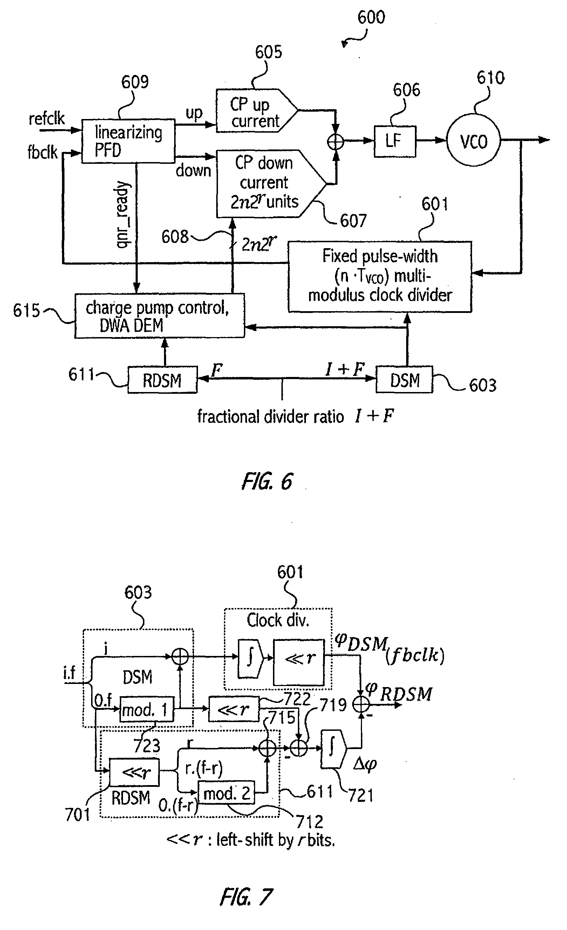

An exemplary fractianal-*N* PLL 600 with charge pump linearization and quantization noise reduction according to an embodiment of the invention is shown in Fig. 6. The PLL 600 includes loop filter 606 and voltage controlled oscillator (VCO) 610. The feedback multi-modulus clock divider 601 is controlled by the DSM 603 as usual, except that its output is a short pulse of a fixed number $n$ of VCO clock periods. Note that for the value of $n$, smaller is better, but $n \cdot T_{VCO}$ should be long enough to accommodate half of peak-to-peak DSM quantization noise with margin. The fbclk and refclk drive the CP 605 and 607 through the linearizing PFD 609. To reduce the quantization noise of the DSM by $r$ bits or $6r$ dB, the down current source 607 is doubled as compared to the up current source 605 and split into $2n \cdot 2^r$ equal units, $n \cdot 2^r$ of which are used on average. In an exemplary embodiment, the current source 605 supplies 160 $\mu$A and the current source 607 is implemented as thirty-two 10 $\mu$A current source units, where n= 4 and r=2. Each unit corresponds to a fbclk phase increment of $\frac{T_{VCO}}{2^r}$. The fictitious RVCO runs $2^r$ times faster than the VCO, and the divide ratio of the associated clock divider would be approximately $2^r$ times greater.

In an exemplary embodiment, the PLL 600 is a type-II fractional-N PLL with a dual-path loop filter in which the integrating path charge pump currents are scaled down from those of the direct path, yet they are controlled by the same up and down pulses from the same PFD. Since the integrating path has low gain for the quantization noise, the reduction technique may be applied to the direct path only. The PLL shown in Fig. 6 is exemplary and noise reduction may be applied to other types of PLLs including those with different loop filters and a different number of down current sources.

The fractional divider ratio is $I + F$, where is $I$ then $i$-bit integer part and $F$ is the $f$-bit fractional part. The fractional portion F is supplied to RDSM 611. The charge pump control logic 615 supplies $2n \cdot 2^r$ control signals 608 to control the $2n \cdot 2^r$ current units in the charge pump down current portion 607 of the charge pump. In the embodiment illustrated, the charge pump control logic 615 is implemented using data weighted averaging dynamic element matching (D WA DEM) in order to suppress the noise generated by the amplitude variation among the $2n \cdot 2^r$ down current source units. Other embodiments may utilize any other appropriate mismatch-shaping dynamic element matching algorithm according to the requirements of the particular implementation.

The charge pump control logic is conceptually shown in Fig. 7. The DSM 603 modulates $F$ into a time-varying integer and adds it to $I$. The sum is the clock divider ratio. In RDSM 611, the fraction F is left shifted by r bits in 701 to generate the $(f - r)$ LSBs of $F$, which are modulated in 712 by RDSM into another time-varying integer, and added to they $r$ MSBs of $F$ in summer 715. If this sum is then added to $I \cdot 2^r$, the result would be the divide ratio of a clock divider based on the hypothesized RVCO clock that generates the rising edge of the down current pulse located at B in Figs. 5A and 5B. Instead, this sum is used with the DSM output to calculate the phase lead of the desired RVCO clock edge over fbclk, denoted $\Delta\varphi$, in units of $\frac{T_{VCO}}{2^r}$. The output of summer 715 is subtracted from a left-shifted output of the modulated F in summer 719. That difference is integrated in integrator 721 to provide the phase lead $\Delta\varphi$. The phase of a clock edge is the time at which it occurs, in units of $\frac{T_{VCO}}{2^r}$. Referring back to Figs. 5A, 5B, and 5C, $\Delta\varphi$ can be seen as the phase lead of edge B over edge A. If $\Delta\varphi$ is positive, that means that the RVCO edge (B) comes before (earlier in time than) the fbclk edge (A). The phase of the desired RVCO clock edge, denoted $\varphi_{RDSM}$, is obtained by subtracting $\Delta\varphi$ from the phase of fbclk, denoted $\varphi_{DSM} \cdot \Delta\varphi + n \cdot 2^r$ is the number of down current source units to be turned on for the present fbclk cycle, where $\Delta\varphi$ has a zero average over time. Referring back to Figs. 2 and 3, the fixed width dn pulse determines how long the down current is supplied (the width of the current pulse) and the fixed value (n-2^r) and the variable value $\Delta\varphi$ determine the magnitude of the dn current. Thus, e.g., assume n=4 and r=2, when $\Delta\varphi$=0,16 current sources are turned on ($n \cdot 2^r$). Referring to Fig. 5B, if $\Delta\varphi$ is positive, then additional charge is required to reduce the quantization error and more than 16 current source elements are selected. If $\Delta\varphi$ is negative, as shown in Fig. 5A, fewer than 16 current source elements are selected. In an exemplary embodiment, both the DSM and RDSM are third-order modulators. In an actual embodiment, there is no need to calculate $\varphi_{RDSM}$ or $\varphi_{DSM}$ as shown in Fig. 7. Only $\Delta\varphi$, the phase difference between the actual feedback clock and the hypothesized feedback clock, needs to be calculated. Note that while one particular embodiment may utilize 32 equal sized current source elements, other embodiments may use weighted current source elements of different sizes and/or a different number of current source elements to provide the down pulse charge.

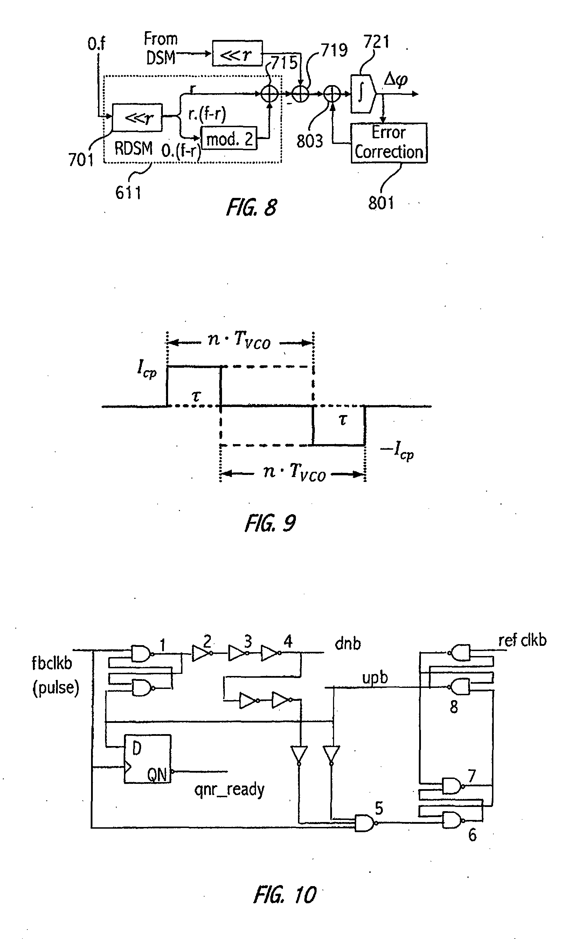

Referring to Fig. 8, illustrated is a self correcting monitor 801 that averages the number of current source elements that are active. If the average is different from a predetermined number of current source elements, e.g., 16, then a signal is provided to summer 803 to adjust the value supplied to integrator 721, which in turn adjusts $\Delta\varphi$ to get the average back to zero. In that way, any errors that happen to occur can be corrected.

Fig. 7 also shows that the quantization noise of the DSM contributes to $\varphi_{RDSM}$ via two paths with gains of the same amplitude but opposite sign. The first path is from the output of the modulator one (mod. 1) 723 in DSM 603 through clock divider 601. The second path is from the output of the modulator one 723 through left-shifter 722 and integrator 721. That quantization noise is cancelled out in $\varphi_{RDSM}$ if there is no analog mismatch.

*Pulse-width Invariant PFD*

The residual errors associated with the quantization noise reduction come from several sources. (1) The cancellation DAC in the form of the down current source units has its own quantization noise, which is proportional to the period of RVCO (2) The amplitude mismatch between the up and down current sources results in imperfect cancellation of the DSM quantization noise. (3) The width of the down pulse may deviate from $n \cdot T_{VCO}$, resulting in error in the charge delivered. At low frequencies this is equivalent to an amplitude mismatch of the down current with up current. Any mismatch between the rise and fall time of the down pulse is equivalent to a width deviation of the down pulse and is included here. (4) Mismatch among the down current source units creates error, although this error is substantially modulated out of the bandwidth of the PLL by dynamic element matching. (5) The shape mismatch of the up and down current pulses due to pulse-width versus pulse-amplitude modulation manifests as imperfect cancellation at high equencies. (6) Due to different path delays in the PFD and CP circuits, the up and down current pulses may be systematically skewed in phase, even when shape mismatch is disregarded.

The second error is equal to the original DSM noise times the relative mismatch, and has the same spectral shaping as the original quantization noise. The second and third errors can be reduced by trimming the up current source relative to the down current sources. For an identically shaped pair of up and down current pulses of amplitude $\pm I_{cp}$ and systematic skew of $\tau$, as shown in Fig. 9, the amplitude of Fourier transform is

$$|F(f)| = 2\tau I_{cp} \cdot \frac{\sin(\pi\tau f)}{\pi\tau f} \cdot \sin(\pi n T_{VCO} f)$$

where the low frequency content is proportional to $\tau$. Therefore, the sixth error above is reduced by minimizing $\tau$.

In the linearizing PFD embodiment of Fig. 4, the rising edges (back edges) of *upb* and *dnb* are well aligned, both at four gate delays after the rising edge of *fbclkb*. However, the dnb pulse is longer than the *fbclkb* pulse of length $n \cdot T_{VCO}$, because its rising edge delay is two gate delays (1-2) while the falling edge delay is four gate delays (3-4-5-2). This causes the third error listed above. The linearizing PFD is therefore modified into the pulse-width invariant PFD (PWI PFD) to overcome this shortcoming, an embodiment of which is shown in Fig. 10, which also has inverted logic sense on inputs and outputs. While the *upb* pulse is produced by a D flip-flop in this PFD, the *dnb* pulse is generated by a single RS latch. The logic and timing of operation of the embodiment shown in Fig. 10 takes advantage of the fact that the rising edge of *fbclkb* should trigger the reset of *dnb* and is self explanatory to those skilled in the art. At the rising edge of *fbclkb*, both *upb* and *dnb* are cleared after four gate delays (1-2-3-4 versus 5-6-7-8). ). Since the falling and rising edges of dnb are triggered by the falling and rising edges of fbclkb, respectively, both after four gate delays (1-2-3-4), the dnb pulse preserves the fbclkb pulse width of $n \cdot T_{VCO}$.

During frequency and phase acquisition, the *refclkb* falling edge may arrive after the rising edge of *fbclkb*. The PWI PFD extends the down pulse width beyond $n \cdot T_{VCO}$, just as the linearizing PFD does. In this case, the basis for the quantization noise reduction technique is not valid, and the technique may interfere with the locking process. A "quantization noise reduction ready" indicator, *qnr_ready*, is created by latching the down pulse output *dnb* with *fbclkb* into a D flip-flop. Quantization noise reduction is active only when *qnr_ready* is high. Otherwise, exactly $n - 2^r$ down current source units should be used.

Note that for the PWI PFD to behave in the same way as the classical PFD during frequency *acquisition, fbclkb* (pulse) should not be stuck low. The PWI PFD can replace the linearizing PFD in Figs. 2 and 4 for use in quantization noise reduction, whereas the linearizing PFD of Figs. 2 and 4 is suitable for stand-alone use in charge pump linearization.

In various embodiments associated with the PFD a method is provided that includes receiving a feedback signal having a fixed pulse width at a first input of a phase frequency detector. Responsive to assertion of the feedback signal, a fixed-with first pulse signal is asserted indicative of a first charge amounts. A reference clock signal is received at a second input of the phase frequency detector. Responsive to assertion of the reference clock signal, second pulse signal is asserted indicating a second charge amount Responsive to an edge of the feedback signal deasserting the feedback signal, the first and second pulse signals deasserted. The method may include, when the reference clock signal lags the feedback signal by more than the fixed pulse width, extending the first pulse signal so that the first pulse signal falls together with the second pulse signal, a fixed delay after the second pulse signal rises. The first pulse signal is for a charge pump and corresponds to a decrease in frequency of a controlled oscillator output signal and the second pulse signal for the charge pump and corresponds to an increase in frequency of the controlled oscillator output signal. The method may further include generating the feedback pulse signal using a feedback divider signal from a feedback divider retimed with an output of a voltage controlled oscillator. The method may further include equally delaying rising and falling edges of the first pulse signal with respect to their triggering conditions. The method may further include providing equal circuit delays for deassertion of the first pulse signal and the second pulse signal, with respect to a common triggering condition. The method may further include latching the second pulse signal with the feedback pulse to provide a quantization noise reduction ready indicator signal. Quantization noise reduction may be enabled according to a value of the quantization noise reduction ready indicator.

In various embodiments associated with the PFD, the PFD includes a first circuit coupled to receive a fixed pulse width feedback signal and supply a first pulse signal having a fixed pulse width corresponding to the fixed pulse width feedback signal, a first edge of the first pulse signal being determined by a first edge of the fixed pulse width feedback signal and a second edge of the first pulse signal being determine by a reset signal. A second circuit is coupled to receive a reference clock signal and to supply a second pulse signal, a first edge of the second pulse signal being determined by a first edge of the reference clock signal and a second edge of the second pulse signal being determined by the reset signal. A reset circuit is responsive to a second edge of the fixed pulse width feedback signal to generate the reset signal. The first and second circuits may comprise respectively, first and second D flip-flops. The first gate delays in the PFD to generate the first edge of the first pulse signal responsive to the first edge of the fixed pulse width feedback signal are equal to second gate delays to generate the second edge of the first pulse signal responsive to the second edge of the fixed pulse width feedback signal. The first gate delays to generate the second edge of the first pulse signal responsive to a triggering condition are equal to second gate delays to generate the second edge of the second pulse signal responsive to the triggering condition and wherein the triggering condition is the second edge of the fixed pulse width feedback signal. The first circuit may comprise an SR latch and the second circuit comprises a D flip-flop. When the reference clock signal lags the feedback signal by more than the fixed pulse width, the reset circuit is operable to extend the first pulse signal by delaying assertion of the reset signal so that the first pulse signal falls together with the second pulse signal, a fixed delay after the second pulse signal rises. A circuit may be coupled to receive the second pulse signal and the feedback clock signal and to latch the second pulse signal using the feedback clock signal and supply an indication thereof as a quantization noise reduction ready indicator. An apparatus including the PFD may include a phase-locked loop including the PFD, a charge pump, a loop filter, a controlled oscillator, and a feedback divider.

The description of the invention set forth herein is illustrative, and is not intended to limit the scope of the invention as set forth in the following claims. Variations and modifications of the embodiments disclosed herein, may be made based on the description set forth herein, without departing from the scope of the invention as set forth in the following claims.

## Claims

1. A method of reducing quantization noise in a fractional-N phase-locked loop comprising:

controlling a multi-modulus feedback divider (601) using a delta sigma modulator (603) coupled to an output signal from a voltage controlled oscillator (610) to supply to a phase frequency detector (609) a feedback pulse signal (fbclk) having a pulse width of a fixed number of periods of the output signal;
supplying the phase frequency detector (609) with a reference clock signal;
generating a first pulse signal (Iup) and a fixed-width second pulse signal (tp) based on the feedback pulse signal (fbclk) and the reference clock signal;
supplying a first current with a first polarity from a first current source (605) according to the first pulse signal from the phase frequency detector (609); and
supplying a second current with a second polarity from a second current source (607) according to the fixed-width second pulse signal and a predetermined first value and a variable second value, the variable second value corresponding to a phase difference between the first feedback pulse signal (fbclk) and a hypothesized feedback clock signal which is defined as being an output signal of a fictitious quantization noise reduction voltage controlled oscillator, the frequency of which is greater than the output signal of the voltage controlled oscillator (610) and is phase-aligned with the voltage controlled oscillator (610).

2. The method as recited in claim 1 further comprising turning on individual ones of current source elements forming the second current source, according to the phase difference and the predetermined first value, wherein the predetermined first value corresponds to a current that is equal and opposite to the first current from the first current source, wherein the fixed-width second pulse signal determines a pulse width of the second current, and the predetermined first value and the variable value determine a magnitude of the second current by determining how many current source elements are turned on in the second current source.

3. The method as recited in claim 2 further comprising determining an average of how many of the current source elements are turned on over time and adjusting a number of current source elements turned on to be a predetermined number of current source elements if the average is not the predetermined number of current source elements.

4. The method as recited in claim 1 further comprising:

   modulating a fractional portion F of a number that includes an integer portion I and the fractional portion F, the fractional portion having (f) bits, to generate a first time varying integer, the number being used to control the multi-modulus feedback divider;
   left shifting the fractional portion F by an integer (r) number of bits and modulating the (f-r) least significant bits of F into a second time varying integer and adding the second time varying integer to (r) most significant bits of the fractional portion F to generate a first sum.

5. The method as recited in claim 4 further comprising:

   subtracting the first sum from the modulated fractional portion F, after the modulated fractional portion F is left-shifted by r bits, to generate a difference;
   integrating the difference to generate the phase difference that corresponds to the second variable value.

6. The method as recited in claim 4 wherein the desired location of the feedback clock signal is based on a hypothesized feedback clock signal and the hypothesized feedback clock signal is based on a hypothesized oscillator output signal that is $2^r$ times faster in terms of frequency than an actual oscillator output signal used to generate the first feedback clock signal.

7. A fractional-N phase-locked loop comprising:

   a multi-modulus feedback divider (601) coupled to an output signal of a voltage controlled oscillator (610);
   a delta sigma modulator (603) adapted to control the multi-modulus feedback divider (601), the multi-modulus feedback divider to supply a feedback pulse signal (fbclk) having a pulse width of a fixed number of periods of the output signal of the voltage controlled oscillator;
   a phase frequency detector (609) coupled to a reference clock signal and the feedback pulse signal (fbclk) to generate a first pulse signal (Iup) and a fixed-width second pulse signal (tp) based on the feedback pulse signal (fbclk) and the reference clock signal;
   a charge pump coupled to the phase-frequency detector including, a first current source (605) to supply a first current of a first polarity responsive to the first pulse signal from the phase frequency detector, and a second current source (607) to supply a second current of a second polarity responsive to the fixed-width second pulse signal and according to a fixed value combined with a variable value, the variable value is a phase difference between the first feedback pulse signal (fbclk) and a hypothesized feedback clock signal which is defined as being an output signal of a fictitious quantization noise reduction voltage controlled oscillator, the frequency of which is greater than the output signal of the voltage controlled oscillator (610) and is phase-aligned with the output signal of the voltage controlled oscillator (610).

8. The fractional-N phase-locked loop as recited in claim 7 wherein the second current source comprises individually controllable unit current sources, and a fixed number of the individually controllable unit current sources correspond to the fixed value and the fixed number is adjusted according to the variable value to enable a number of the individually controllable unit current sources to provide the second current; and wherein on average, the fixed number of current sources are turned on.

9. The fractional-N phase-locked loop as recited in claim 7 further comprising an error correction circuit (801) coupled to average the number of current source elements turned on and to adjust a number of current source elements turned on to make the average the fixed number of the current source elements.

**10.** The fractional-N phase-locked loop as recited in claim 7 further comprising a loop filter (606) coupled to the first and second current sources, and the controlled oscillator (610) coupled to the loop filter and adjusted according to a difference between the first and second charge amounts supplied respectively by the first and second currents.

**11.** The fractional-N phase-locked loop as recited in claim 7 wherein:

the delta sigma modulator (603) is adapted to modulate a fractional portion F with (f) bits, of a number that includes an integer I and the fractional portion F, to generate a first time varying integer, the number being used to control the feedback divider circuit;

and further comprising:

a shift circuit (701) adapted to left shift the fractional portion F by an integer (r) number of bits;
a second circuit (712) adapted to modulate (f-r) least significant bits of F into a second time varying integer; and
a summer circuit (715) adapted to add the second time varying integer to r most significant bits of the fractional portion F to generate a first sum;

wherein the second circuit comprises a second delta sigma modulator.

**12.** The fractional-N phase-locked loop as recited in claim 11 further comprising:

a difference circuit (719) adapted to subtract the first sum from the modulated fractional portion F, after the modulated fractional portion F is left-shifted by r bits, to generate a difference;
an integrator (721) adapted to integrate the difference to generate the phase difference corresponding to the variable value.

**13.** The fractional-N phase-locked loop as recited in claim 7 wherein the first current source is the up current source and the second current source is the down current source.

**14.** The fractional-N phase-locked loop as recited in claim 7 wherein the fixed-width second pulse signal determines how long the second current is supplied and the fixed value and the variable value determine magnitude of the second current.

## Patentansprüche

**1.** Verfahren zum Reduzieren des Quantisierungsrauschens in einem Fractional-N-PLL (Phasenregelkreis), das Folgendes umfasst:

Steuern eines Multi-Modulus-Rückkopplungsteilers (601), unter Verwendung eines Delta-Sigma-Modulators (603), der an ein Ausgangssignal von einem spannungsgesteuerten Oszillator (610) gekoppelt ist, um einem Phasenfrequenzdetektor (609) ein Rückkopplungstaktsignal (fbclk) zu liefern, wobei das Rückkopplungstaktsignal eine Taktbreite, die einer festen Anzahl von Perioden des Ausgangssignals entspricht, hat;
Versorgen des Phasenfrequenzdetektors (609) mit einem Referenztaktsignal;
Generieren eines ersten Taktsignals (Iup) und eines zweiten Taktsignals (tp) mit fester Breite auf der Basis des Rückkopplungstaktsignals (fbclk) und des Referenztaktsignals;
Liefern eines ersten Stroms mit einer ersten Polarität von einer ersten Stromquelle (605) gemäß dem ersten Taktsignal des Phasenfrequenzdetektors (609); und
Liefern eines zweiten Stroms mit einer zweiten Polarität von einer zweiten Stromquelle (607) gemäß dem zweiten Taktsignal mit fester Breite und einem vorbestimmten ersten Wert und einem variablen zweiten Wert, wobei der variable zweite Wert eine Phasendifferenz zwischen dem ersten Rückkopplungstaktsignal (fbclk) und einem hypothetischen Rückkopplungstaktsignal entspricht, das als ein Ausgangssignal eines fiktiven spannungsgesteuerten Quantisierungsrauschreduktionsoszillators definiert ist, dessen Frequenz größer als das Ausgangssignal des spannungsgesteuerten Oszillators (610) ist und bezüglich der Phase auf den spannungsgesteuerten Oszillator (610) ausgerichtet ist.

**2.** Verfahren nach Anspruch 1, weiterhin umfassend das Einschalten individueller von die zweite Stromquelle bildenden Stromquellenelementen gemäß der Phasendifferenz und dem vorbestimmten ersten Wert, wobei der vorbestimmte erste Wert einem Strom entspricht, der dem ersten Strom von der ersten Stromquelle gleich und entgegengesetzt ist, wobei das zweite Taktsignal mit fester Breite eine Taktbreite des zweiten Stroms bestimmt und der vorbestimmte erste Wert und der variable Wert eine Größe des zweiten Stroms bestimmen, indem sie bestimmen, wie viele Stromquellenelemente in der zweiten Stromquelle eingeschaltet sind.

3. Verfahren nach Anspruch 2, weiterhin umfassend das Bestimmen eines Mittelwerts über der Zeit dessen, wie viele der Stromquellenelemente eingeschaltet sind, und Anpassen einer Anzahl eingeschalteter Stromquellenelemente auf eine vorbestimmte Anzahl von Stromquellenelementen, falls der Mittelwert nicht die vorbestimmte Anzahl an Stromquellenelementen ist.

4. Verfahren nach Anspruch 1, das weiterhin Folgendes umfasst:

Modulieren eines Bruchteils F einer Zahl, die einen ganzzahligen Teil I und den Bruchteil F enthält, wobei der Bruchteil (f) Bits aufweist, zum Generieren einer ersten zeitlich variierenden ganzen Zahl, wobei die Zahl zum Steuern des Multi-Modulus-Rückkopplungsteilers verwendet wird;
Linksverschieben des Bruchteils F um eine ganzzahlige (r) Anzahl von Bits und Modulieren der (f-r) am wenigsten signifikanten Bits von F zu einer zweiten zeitlich variierenden ganzen Zahl und Addieren der zweiten zeitlich variierenden ganzen Zahl zu (r) höchst signifikanten Bits des Bruchteils F, um eine erste Summe zu generieren.

5. Verfahren nach Anspruch 4, das weiterhin Folgendes umfasst:

Subtrahieren der ersten Summe von dem modulierten Bruchteil F, nachdem der modulierte Bruchteil F um r Bits nach links verschoben ist, um eine Differenz zu generieren; Integrieren der Differenz, um die Phasendifferenz zu generieren, die dem zweiten variablen Wert entspricht.

6. Verfahren nach Anspruch 4, wobei der gewünschte Ort des Rückkopplungstaktsignals auf einem hypothetischen Rückkopplungstaktsignal basiert und das hypothetisierte Rückkopplungstaktsignal auf einem hypothetisierten Oszillatorausgangssignal basiert, das bezüglich Frequenz $2^r$-mal schneller ist als ein zum Generieren des ersten Rückkopplungstaktsignals verwendetes tatsächliches Oszillatorausgangssignal.

7. Fractional-N-Phasenregelkreis (PLL), der Folgendes umfasst:

einen Multi-Modulus-Rückkopplungsteiler (601), der an ein Ausgangssignal eines spannungsgesteuerten Oszillators (610) gekoppelt ist,
einen Delta-Sigma-Modulator (603), der zum Steuern des Multi-Modulus-Rückkopplungsteilers (601) ausgelegt ist, wobei der Multi-Modulus-Rückkopplungsteiler (601) ein Rückkopplungstaktsignal (fbclk) liefern soll, wobei das Rückkopplungstaktsignal eine Taktbreite, die einer festen Anzahl von Perioden des Ausgangssignals des spannungsgesteuerten Oszillators entspricht, hat;
einen Phasenfrequenzdetektor (609), der an ein Referenztaktsignal und das Rückkopplungstaktsignal (fbclk) gekoppelt ist, um ein erstes Taktsignal (Iup) und ein zweites Taktsignal (tp) mit fester Breite auf der Basis des Rückkopplungsimpulssignals (fbclk) und des Referenztaktsignals zu generieren;
eine Ladungspumpe, die an den Phasenfrequenzdetektor gekoppelt ist, und eine erste Stromquelle (605) zum Liefern eines ersten Stroms mit einer ersten Polarität als Reaktion auf das erste Taktsignal von dem Phasenfrequenzdetektor und eine zweite Stromquelle (607) zum Liefern eines zweiten Stroms mit einer zweiten Polarität als Reaktion auf das zweite Taktsignal mit fester Breite und gemäß einem festen ersten Wert kombiniert mit einem variablen Wert aufweist, wobei der variable Wert eine Phasendifferenz zwischen dem ersten Rückkopplungstaktsignal (fbclk) und einem hypothetischen Rückkopplungstaktsignal ist, das als ein Ausgangssignal eines fiktiven spannungsgesteuerten Quantisierungsrauschreduktionsoszillators definiert ist, dessen Frequenz größer als das Ausgangssignal des spannungsgesteuerten Oszillators (610) ist und bezüglich der Phase auf das Ausgangssignal des spannungsgesteuerten Oszillator (610) ausgerichtet ist.

8. Fractional-N-Phasenregelkreis nach Anspruch 7, wobei die zweite Stromquelle individuell steuerbare Einheitsstromquellen umfasst und eine feste Anzahl der individuell steuerbaren Einheitsstromquellen dem festen Wert entsprechen und die feste Anzahl gemäß dem variablen Wert verstellt wird, damit eine Anzahl der individuell steuerbaren Einheitsstromquellen den zweiten Strom liefern kann; und wobei im Mittel die feste Anzahl von Stromquellen eingeschaltet ist.

9. Fractional-N-Phasenregelkreis nach Anspruch 7, weiterhin umfassend eine Fehlerkorrekturschaltung (801), die zum Mitteln der Anzahl an eingeschalteten Stromquellenelementen und zum Verstellen einer Anzahl an eingeschalteten Stromquellenelementen geschaltet ist, um dafür zu sorgen, dass der Mittelwert der festen Anzahl der Stromquellenelemente entspricht.

10. Fractional-N-Phasenregelkreis nach Anspruch 7, weiterhin umfassend ein Schleifenfilter (606), das an die erste und zweite Stromquelle gekoppelt ist und wobei der gesteuerte Oszillator (610) an das Schleifenfilter gekoppelt ist und gemäß einer Differenz zwischen der ersten und zweiten Lademenge, die jeweils durch den ersten und zweiten Strom geliefert werden, angepasst wird.

11. Fractional-N-Phasenregelkreis nach Anspruch 7, wobei:

der Delta-Sigma-Modulator (603) zum Modulieren eines Bruchteils F mit (f) Bits einer Anzahl, die eine ganze Zahl I und den Bruchteil F enthält, ausgelegt ist, um eine erste zeitlich variierende ganze Zahl zu generieren, wobei die Anzahl zum Steuern der Rückkopplungsteilerschaltung verwendet wird; und weiterhin umfassend:

eine Schiebeschaltung (701), zum Linksverschieben des Bruchteils F um eine ganzzahlige (r) Anzahl von Bits;
eine zweite Schaltung (712), zum Modulieren (f-r) am wenigsten signifikanter Bits von F in eine zweite zeitlich variierende ganze Zahl; und
eine Summiererschaltung (715), zum Addieren der zweiten zeitlich variierenden ganzen Zahl zu r höchst signifikanten Bits des Bruchteils F, um eine erste Summe zu generieren;

wobei die zweite Schaltung einen zweiten Delta-Sigma-Modulator umfasst.

12. Fractional-N-Phasenregelkreis nach Anspruch 11, der weiterhin Folgendes umfasst:

eine Differenzschaltung (719), ausgelegt zum Subtrahieren der ersten Summe von dem modulierten Bruchteil F, nachdem der modulierte Bruchteil F um r Bits linksverschoben ist, zum Generieren einer Differenz;
einen Integrierer (721), ausgelegt zum Integrieren der Differenz zum Generieren der Phasendifferenz entsprechend dem variablen Wert.

13. Fractional-N-Phasenregelkreis nach Anspruch 7, wobei die erste Stromquelle die Aufwärts-Stromquelle ist und die zweite Stromquelle die Abwärts-Stromquelle ist.

14. Fractional-N-Phasenregelkreis nach Anspruch 7, wobei das zweite Impulssignal mit fester Breite bestimmt, wie lange der zweite Strom geliefert wird und der feste Wert und der variable Wert die Größe des zweiten Stroms bestimmen.

**Revendications**

1. Procédé de réduction du bruit de quantification dans une boucle à verrouillage de phase N-fractionnaire, comprenant :

la commande d'un diviseur de retour modulo-multiple (601) au moyen d'un modulateur delta sigma (603) couplé à un signal de sortie émanant d'un oscillateur contrôlé en tension (610) pour fournir à un détecteur phase-fréquence (609) un signal à impulsion de retour (fbclk) ayant une largeur d'impulsion d'un nombre fixe de périodes du signal de sortie ;
la fourniture au détecteur phase-fréquence (609) d'un signal d'horloge de référence ;
la production d'un premier signal à impulsion (Iup) et d'un second signal à impulsion de largeur fixe (tp) sur la base du signal à impulsion de retour (fbclk) et du signal d'horloge de référence ;
la fourniture d'un premier courant ayant une première polarité à partir d'une première source de courant (605) en fonction du premier signal à impulsion émanant du détecteur phase-fréquence (609) ; et
la fourniture d'un second courant ayant une seconde polarité à partir d'une seconde source de courant (607) en fonction du second signal à impulsion de largeur fixe et d'une première valeur prédéterminée et d'une seconde valeur variable, la seconde valeur variable correspondant à une différence de phase entre le premier signal à impulsion de retour (fbclk) et un signal d'horloge de retour hypothétique qui est défini comme étant un signal de sortie d'un oscillateur fictif contrôlé en tension à réduction du bruit de quantification dont la fréquence

11

est supérieure à celle du signal de sortie de l'oscillateur contrôlé en tension (610) et est aligné en phase avec l'oscillateur contrôlé en tension (610).

**2.** Procédé selon la revendication 1 comprenant en outre l'activation de chacun des éléments de source de courant formant la seconde source de courant, en fonction de la différence de phase et de la première valeur prédéterminée, la première valeur prédéterminée correspondant à un courant qui est égal et opposé au premier courant émanant de la première source de courant,
dans lequel le second signal à impulsion de largeur fixe détermine une largeur d'impulsion du second courant, et la première valeur prédéterminée et la valeur variable déterminent une amplitude du second courant en déterminant le nombre d'éléments de source de courant activés dans la seconde source de courant.

**3.** Procédé selon la revendication 2, comprenant en outre la détermination d'une moyenne du nombre d'éléments de source de courant étant activés dans le temps et le réglage du nombre d'éléments de source de courant activés pour qu'il soit égal à un nombre prédéterminé d'éléments de source de courant si la moyenne n'est pas le nombre prédéterminé d'éléments de source de courant.

**4.** Procédé selon la revendication 1 comprenant en outre :

la modulation d'une partie fractionnaire F d'un nombre qui comprend une partie entière I et la partie fractionnaire F, la partie fractionnaire ayant (f) bits, pour produire un premier nombre entier variant dans le temps, ledit nombre servant à commander le diviseur de retour modulo-multiple ;
le décalage à gauche de la partie fractionnaire F d'un nombre entier (r) de bits et la modulation des (f-r) bits de poids faible de F en un second nombre entier variant dans le temps et l'ajout du second nombre entier variant dans le temps à (r) bits de poids fort de la partie fractionnaire F pour produire une première somme.

**5.** Procédé selon la revendication 4 comprenant en outre :

la soustraction de la première somme de la partie fractionnaire F modulée, après que la partie fractionnaire F modulée a été décalée à gauche de r bits, pour produire une différence ;
l'intégration de la différence pour produire la différence de phase qui correspond à la seconde valeur variable.

**6.** Procédé selon la revendication 4 dans lequel l'emplacement souhaité du signal d'horloge de retour est basé sur un signal d'horloge de retour hypothétique et le signal d'horloge de retour hypothétique est basé sur un signal de sortie hypothétique de l'oscillateur qui est $2^r$ fois plus rapide en termes de fréquence que le signal de sortie réel de l'oscillateur utilisé pour produire le premier signal d'horloge de retour.

**7.** Boucle à verrouillage de phase N-fractionnaire comprenant :

un diviseur de retour modulo-multiple (601) couplé à un signal de sortie d'un oscillateur contrôlé en tension (610) ;
un modulateur delta sigma (603) adapté pour commander le diviseur de retour modulo-multiple (601), le diviseur de retour modulo-multiple étant destiné à fournir un signal à impulsion de retour (fbclk) ayant une largeur d'impulsion d'un nombre fixe de périodes du signal de sortie de l'oscillateur contrôlé en tension ;
un détecteur phase-fréquence (609) couplé à un signal d'horloge de référence et au signal à impulsion de retour (fbclk) pour produire un premier signal à impulsion (Iup) et un second signal à impulsion de largeur fixe (tp) sur la base du signal à impulsion de retour (fbclk) et du signal d'horloge de référence ;
une pompe de charge couplée au détecteur phase-fréquence et comprenant une première source de courant (605) destinée à fournir un premier courant d'une première polarité en réponse au premier signal à impulsion émanant du détecteur phase-fréquence, et une seconde source de courant (607) destinée à fournir un second courant d'une seconde polarité en réponse au second signal à impulsion de largeur fixe et en fonction d'une valeur fixe associée à une valeur variable, la valeur variable étant une différence de phase entre le premier signal à impulsion de retour (fbclk) et un signal d'horloge de retour hypothétique qui est défini comme étant un signal de sortie d'un oscillateur fictif contrôlé en tension à réduction du bruit de quantification dont la fréquence est supérieure à celle du signal de sortie de l'oscillateur contrôlé en tension (610) et est aligné en phase avec l'oscillateur contrôlé en tension (610).

**8.** Boucle à verrouillage de phase N-fractionnaire selon la revendication 7, dans laquelle la seconde source de courant comprend des sources de courant unitaires pouvant être commandées individuellement, et un nombre fixe des sources de courant unitaires pouvant être commandées individuellement correspondent à la valeur fixe et le nombre fixe est réglé en fonction de la valeur variable pour permettre à un certain nombre des sources de courant unitaires pouvant être commandées individuellement de fournir le second courant ; et dans laquelle en moyenne, le nombre fixe de sources de courant sont activées.

9. Boucle à verrouillage de phase N-fractionnaire selon la revendication 7, comprenant en outre un circuit de correction des erreurs (801) couplé pour faire la moyenne du nombre d'éléments de source de courant activés et pour régler le nombre d'éléments de source de courant activés pour rendre la moyenne égale au nombre fixe des éléments de source de courant.

10. Boucle à verrouillage de phase N-fractionnaire selon la revendication 7 comprenant en outre un filtre à boucle (606) couplé aux première et seconde sources de courant, et l'oscillateur contrôlé (610) couplé au filtre à boucle et réglé en fonction d'une différence entre les première et seconde quantités de charge fournies respectivement par les premier et second courants.

11. Boucle à verrouillage de phase N-fractionnaire selon la revendication 7 dans laquelle :

le modulateur delta sigma (603) est adapté pour moduler une partie fractionnaire F comportant (f) bits, d'un nombre qui comprend un nombre entier I et la partie fractionnaire F, pour produire un premier nombre entier variant dans le temps, ledit nombre servant à commander le circuit diviseur de retour ;
et comprenant en outre :

un circuit de décalage (701) adapté pour décaler à gauche la partie fractionnaire F d'un nombre entier (r) de bits ;
un second circuit (712) adapté pour moduler (f-r) bits de poids faible de F en un second nombre entier variant dans le temps ; et
un circuit de sommation (715) adapté pour ajouter le second nombre entier variant dans le temps à r bits de poids fort de la partie fractionnaire F pour produire une première somme ;

dans laquelle le second circuit comprend un second modulateur delta sigma.

12. Boucle à verrouillage de phase N-fractionnaire selon la revendication 11, comprenant en outre :

un circuit de différence (719) adapté pour soustraire la première somme de la partie fractionnaire F modulée, après que la partie fractionnaire F modulée a été décalée à gauche de r bits, pour produire une différence ;
un intégrateur (721) adapté pour intégrer la différence afin de produire la différence de phase correspondant à la valeur variable.

13. Boucle à verrouillage de phase N-fractionnaire selon la revendication 7 dans laquelle la première source de courant est la source de courant élévateur et la seconde source de courant est la source de courant abaisseur.

14. Boucle à verrouillage de phase N-fractionnaire selon la revendication 7 dans laquelle le second signal à impulsion de largeur fixe détermine la durée pendant laquelle le second courant est fourni et la valeur fixe et la valeur variable déterminent l'amplitude du second courant.

FIG. 1A

fbclk leads refclk

fbclk lags refclk

FIG. 1B

FIG. 1C

**FIG. 2**

**FIG. 3**

*FIG. 4*

fbclk leads refclk *FIG. 5A*

fbclk lags refclk

*FIG. 5B*

*FIG. 5C*

FIG. 6

$\ll r$ : left-shift by $r$ bits.

FIG. 7

FIG. 8

FIG. 9

FIG. 10

**EP 2 369 745 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007126484 A1